# EUROPÄISCHE PATENTSCHRIFT

(11) **EP 0 354 225 B1**
(45) Veröffentlichungstag und Bekanntmachung des Hinweises auf die Patenterteilung: **09.03.1994**
(21) Anmeldenummer: 89900178.8
(22) Anmeldetag: 22.12.1988
(51) Int. Cl.: G01S 13/78, G07C 11/00, G08B 13/24, H01G 13/00, H04B 1/59

(54) **VERFAHREN ZUR FREQUENZBANDANPASSUNG EINES SCHWINGKREISES AUS METALL-KUNSTSTOFF-METALL-VERBUNDFOLIE FÜR EINE IDENTIFIKATIONSETIKETTE**
PROCESS FOR ADAPTING THE FREQUENCY BAND OF AN OSCILLATING CIRCUIT MADE FROM A METAL-PLASTIC-METAL SANDWICH FOIL USEFUL AS AN IDENTIFICATION LABEL
PROCEDE D'ADAPTATION DE LA BANDE DE FREQUENCE D'UN CIRCUIT RESONNANT FORME PAR UNE FEUILLE COMPOSITE EN METAL-PLASTIQUE-METAL POUR ETIQUETTES D'IDENTIFICATION

(30) Priorität: 23.12.1987 DE 3743863; 04.06.1988 DE 3819106
(43) Veröffentlichungstag der Anmeldung: 14.02.1990
(60) Teilanmeldung: 93103162.9
(73) Patentinhaber: ALUSUISSE-LONZA SERVICES AG, 8034 Zürich (CH)
(72) Erfinder: OEHLMANN, Klaus, D-7707 Engen 5 (DE)
(86) Internationale Anmeldenummer: CH8800227
(87) Internationale Veröffentlichungsnummer: WO8905984

(56) Entgegenhaltungen:
- EP-A- 0 209 816
- WO-A-86/02186
- WO-A-86/04172
- US-A- 3 671 721
- US-A- 3 947 934

## Beschreibung

Die Erfindung betrifft ein Verfahren zur Frequenzbandanpassung von Schwingkreisen aus MetallKunststoff-Metall-Verbundfolie für Identifikationsetiketten.

Identifikationsetiketten werden mit einem Schwingkreis, z.B. bei Diebstahlsicherungsetiketten, oder mehreren Schwingkreisen, beispielsweise bei Zuordnungen von Objekten wie Paketen, Koffern oder in gewissen Ländern bei Fahrzeugen zur Berechnung der Strassenbenutzungsgebühren, zur berührungslosen, räumlich nicht fixierten Identifikation verwendet.

Die Herstellung und Verwendung der Schwingkreise aus Metall-Kunststoff-Metall-Verbundfolie für derartige Identifikationsetiketten ist an sich aus den Schriften US-PS 3.671.721 und W0 86/02186 bekannt. Zu Verwendung der Schwingkreise als Identifikationsetikette(n) ist es notwendig, dass jeder Schwingkreis als Störglied für Hochfrequenzfelder innerhalb eines genau vorgegebenen Frequenzbandes mit enger Toleranz anspricht und dadurch beispielsweise bei Verwendung einer Etikette als Diebstahlsicherung ein optisches oder akustisches Signal ausgelöst wird.

Ein Schwingkreis kann aus einer MetallKunststoff-Metall-Verbundfolie hergestellt werden, die von der Materialauswahl einen hohen Qualitätsstandard darstellt und kontinuierlich gefertigt werden kann. Schwierigkeiten bereitet die grosstechnische Fertigung bzw. Massenproduktion von Schwingkreisstrukturen aus Metall-Kunststoff-Metall-Verbundfolien, weil die Fertigungsparameter und vor allem die Dickentoleranzen der eingesetzten Schichten der Verbundfolie sowie die zur Darstellung der einzelnen Schwingkreise bedingten Folienveränderungen einen erheblichen Einfluss auf die Ansprechfrequenzen des fertigen Schwingkreiseshaben.

Um die Frequenzgenauigkeit von Schwingkreisen auf Metall-Kunststoff-Me - tall-Verbundfolien zu erhöhen, beschreibt die EP-A1-0209816 ein Verfah - ren zur Frequenzkorrektur von in dieser Weise aufgebauten Schwingkreisen durch Nacharbeit mittels Laserstrahlen. Durch die Verwendung von nur einer einzelnen Resonanzfrequenz-Messzelle macht dieses Verfahren keinen Gebrauch von der Eigenschaft der sich stetig verändernden Frequenzeigenschaften von Schwingkreisen auf Verbundfolienrollenware und ist deshalb für eine schnelle und kontinuierlich arbeitende Trimmvorrichtung für solche Schwingkreise nicht geeignet.

Die Erfinder haben sich daher die Aufgabe gestellt, ein geeignetes Verfahren anzugeben, mit dessen Hilfe es möglich ist, mit hoher Geschwindigkeit quasi kontinuierlich und vollautomatisch bei aus Verbundfolienrollenware hergestellten Schwingkreisen für Identifikationsetiketten die Frequenzen auf einen bestimmten Frequenzbandwert anzupassen.

Erfindungsgemäss wird dies durch die Merkmale des Anspruchs 1 gelöst. Weitere Ausführungsformen des erfindungsgemässen Verfahrens zeichnen sich nach dem Wortlaut der Ansprüche 2 bis 12 aus.

Das oben und auch nachfolgend als Verbundfolienrollenware oder dgl. gekennzeichnete Material muss nicht zwingend als Rollenware vorliegen. Obwohl üblicherweise in Form von Rollen gelagert und verarbeitet, kann es durchaus auch als endlose Bahn in einer gefalteten Packung vorliegen und dem erfindungsgemässen Verfahren unterzogen werden.

Die sich auf einer quasi endlosen Bahn befindenden und zu überprüfenden elektrischen Schwingkreise, von denen jeder einen in sich abgeschlossenen Stromkreis aufweist, wobei sich auf der einen Seite der Verbundfolie eine spiralförmig angeordnete, eine Induktionsspule bildende, Leiterstruktur sowie eine erste Kondensatorfläche aus Metall befinden und auf der anderen Verbundfolienseite eine der ersten Kondensatorfläche gegenüberliegende zweite Kondensatorfläche mit einer im Vergleich zur ersten Kondensatorfläche dünneren Metallschicht vorhanden ist, werden nacheinander durch eine erste Messzelle geführt, dort vorzugsweise mit Hilfe oszillierender Frequenzen die Ist-Frequenz eines jeden Schwingkreises festgestellt und mit der vorgegebenen Sollfrequenz verglichen. Die ermittelte Differenz dient als Bezugsgrösse für ein gezieltes Einkürzen des Kondensatorteils des Schwingkreises zur Erreichung der Soll-Frequenz. Durch Einkürzen der Kondensatorfläche wird die Kapazität so verändert, dass die endgültige Frequenz des Schwingkreises in der vorgegebenen Soll-Frequenzbandbreite liegt. Dann wird in einem nachfolgenden Messgang mit einer zweiten Messzelle überprüft, ob der gewünscht Sollwert erreicht wurde bzw. der Schwingkreis nun innerhalb des akzeptablen Frequenzbandes liegt. Das Ergebnis wird anschliessend an die Korrektureinheit, welche bereits den Einkürzungsvorgang mit Hilfe einer Einkürzeinheit steuerte, gemeldet, so dass die Abweichung vom Sollwert bei der nächsten Schwingkreisanpassung berücksichtigt wird.

Da bei sorgfältiger Wahl der Komponenten und deren Dimensionen der bahnförmigen Materialien der hier in Frage kommenden Art nicht mit einer sprunghaften Veränderung der Dimensionen der einzelnen Folien oder diese verbindenden Mittel zu rechnen ist, ist auch kaum mit einer starken Abweichung der Frequenz eines in nicht zu weitem Abstand nachfolgenden Schwingkreises gegenüber einem vorhergehenden zu erwarten. Es hat sich gezeigt, dass ein Abstand von etwa 450 mm, was bei der heutigen Schwingkreisgrösse von ca. 50 mm etwa 9 Schwingkreise ausmacht, nur eine unwesentliche Frequenzveränderung auftritt. Die beim vorhergehenden Schwingkreis ermittelte Abweichung des Ist-Frequenzwertes vom Sollwert stimmt daher etwa auch mit dem nachfolgenden Schwingkreis überein, so dass die aus dem vorhergemessenen Schwingkreis ermittelte Stellung der Einkürzeinheit für den Einkürzungsvorgang eines innerhalb eines solchen Abstandes nachfolgenden Schwingkreises in erster Näherung auch zutreffend ist. Daher berücksichtigt die Steuereinheit diesen Stellungswert der Einkürzeinheit als Basiswert bei der Ermittlung der Korrektur für den nachfolgenden auf das vorgegebene Frequenzband anzupassenden Schwingkreis, indem sie diesen Stellungswert als Basis belässt und für die endgültige Stellungskorrektur der Einkürzeinheit nur noch geringe Korrekturen von der Basisstellung vornimmt. Liegt diese geringe Korrektur innerhalb der tolerierbaren Frequenzbandbreite und ist wie beispielsweise bei mechanischen Werkzeugen wie Stanzen oder Scheren, die zur Herbeiführung der erforderlichen Einkürzung notwendige Fahrstreckenkorrektur innerhalb der mechanisch bedingten kleinstmöglichen Fahrstreckenkorrektur, so wird auf das Einkürzen verzichtet.

Durch diese Vorgehensweise kann die Anpassung von auf Verbundfolienrollenware oder dgl. befindlichen Schwingkreisen auf ein bestimmtes Frequenzband mit hoher Geschwindigkeit vollautomatisch und quasi kontinuierlich erfolgen.

Das Einkürzen des Kondensatorteils kann mit Hilfe von mechanischen Stanz- oder Schneidwerkzeugen, durch Hochdruckwasserstrahl, durch Funkenerosion oder durch Beschneiden mit Hilfe eines Laserstrahls erfolgen. Um einen Kurzschluss der beiden Kondensatorflächen zu vermeiden, muss das Einkürzen des Kondensatorteils derart erfolgen, dass keine elektrisch leitende Verbindung der beiden Metallschichten über das im wesentlichen aus Kunststoff bestehende Dielektrikum hinweg erzeugt wird, die zum Versagen des Kondensators und damit der Identifikationsetikette führen würde.

Durch entsprechende Konstruktion ist es auch möglich, insbesondere bei der Benutzung von einem Laserstrahl, zum Einkürzen der Kondensatorflächen eine Messzelle, vorzugsweise die erste, so auszuführen, dass die Einkürzeinheit in der Messzelle integriert ist. Es ist aber auch wegen der bereits oben erwähnten geringen Dimensionsänderungen geeigneter Metall-Kunststoff-Metall-Verbundfolien möglich, die Messzellen bis etwa zum zehnten Schwingkreis voneinander entfernt anzuordnen und insbesondere bei mechanischen Einkürzungsvorrichtungen somit einen Basisstellungswert eines ersten Schwingkreises als Grundlage für einen Schwingkreis zu machen, der erst neun Schwingkreise nach dem ersten folgt, ohne dass dadurch weder die Frequenzbandanpassungstoleranz noch die Anpassungsgeschwindigkeit darunter leiden. Bei den zur Zeit üblichen Abmessungen der Schwingkreise von um 50 mm bedeutet das, dass die Messzellen in einem Abstand von 450 mm angeordnet sein können, so dass die verschiedenen in den Ansprüchen 3 bis 7 gekennzeichneten Werkzeuge für die Einkürzeinheit ohne Schwierigkeiten montiert werden können, auch wenn sie aufgrund ihrer konstruktiven Eigenheiten relativ gross dimensioniert ausfallen.

Voraussetzung bei dem erfindungsgemässen Verfahren ist, dass die vor der Anpassung des Schwingkreises vorliegende Kapazität des Kondensators stets grösser ist als die für die innerhalb der Frequenzbandbreite liegende, angestrebte Frequenz notwendige Kapazität. Es wird daher generell von vorne herein von einer zu hohen Kapazität als Ist-Kapazität ausgegangen und durch Einkürzen der Kondensatorflächen die immer niedriger liegende Soll-Kapazität angestrebt.

Zur Durchführung des erfindungsgemässen Verfahrens eignet sich insbesondere eine Metall-Kunststoff-Metall-Verbundfolie, bei der das Metall Aluminium oder eine Aluminiumlegierung ist. Die Kunststoffschicht besteht vorteilhaft aus einem Stoff mit möglichst niedrigem dielektrischem Verlustfaktor, wobei die Wahl des Stoffs und die Ausbildung der Schicht so gewählt bzw. bemessen ist, dass die Stabilität eines Schwingkreises nicht beeinträchtigt wird.

Eine weitere zur Durchführung des erfindungsgemässen Verfahrens geeignete Ausgestaltung der Verbundfolie besteht in der zusätzlichen Anordnung von weiteren Dielektrikumsschichten neben der Kunststoffschicht, welche gleichzeitig die Haftung zur Aluminium- oder Aluminiumlegierungsschicht verbessern. Als besonders geeignet haben sich Stoffe mit geringem dielektrischen Verlustfaktor und guter Aetzbeständigkeit erwiesen. Dabei ist es erforderlich, dass bei Verwendung niedrig polarer Stoffe die Schichtdicke dieser Stoffe möglichst gering ist und bei Stoffen mit mittlerer bis hoher Polarität die Schichtdicke grösser gewählt wird.

Bevorzugt werden Verbundfolien verwendet, deren Schwingkreise durch partielles oder vollflächiges Auftragen von ein- oder zweikomponentigen Aetzresistschichten im Rotations- oder Kupfertiefdruckverfahren auf die Aluminium- oder Aluminiumlegierungsschicht(en) und nach deren Trocknung bzw. Aushärtung durch Wärme, Licht oder sonstige Strahlung, durch Abätzen der nicht durch die Aetzresistschicht bedeckten Teile oder bei vollflächiger Auftragsart der Aetzresistschicht nach deren für die Herstellung der Leiterbahnstrukturen notwendigen Entfernung durch an sich übliche Verfahren wie beispielsweise Belichten, Aushärten oder Auswaschen in einer Kombination von alkalischen und sauren Bädern, die die Metall-Kunststoff-Metall-Verbundfolie als quasi endlose Bahn durchläuft, in einem kontinuierlichen Prozess hergestellt sind.

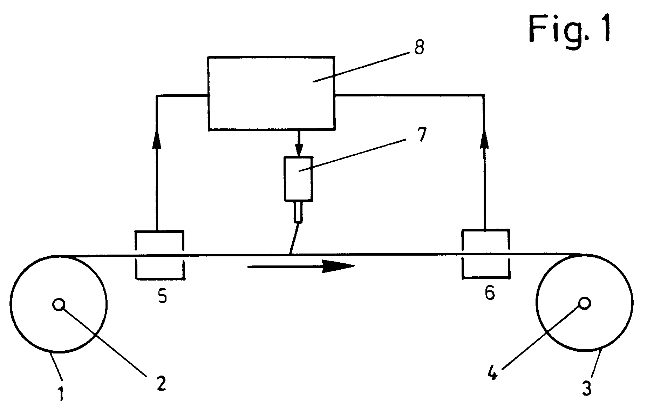

Weitere Vorteile, Merkmale und Einzelheiten der Erfindung sind der nachfolgenden Beschreibung im Zusammenhang mit der Zeichnung zu entnehmen. Diese zeigt schematisch in:
- Fig. 1: eine Anordnung zur Durchführung des erfindungsgemässen Verfahrens,
- Fig. 2: einen beispielhaften Querschnitt einer Verbundfolie zur Durchführung des erfindungsgemässen Verfahrens,
- Fig. 3: einen Schwingkreiskondensator nach Frequenzanpassung,
Wie Figur 1 zeigt, befinden sich die aus der Verbundfolie herausgearbeiteten Schwingkreise als Verbundfolienrollenware 1 auf einer Haspel 2 und werden in Pfeilrichtung auf die Haspel 4 als Verbundfolienrollenware 3 überführt. Zwischen den Haspeln befinden sich zwei Frequenzmesszellen 5, 6, zwischen denen die Einkürzeinheit 7 angeordnet ist, welche über die Korrektureinheit 8 gesteuert wird. Die einzelnen Schwingkreise sind durch die gemeinsame Kunststoffolie miteinander verbunden und werden so quasi kontinuierlich den Frequenzmesszellen 5, 6 zugeführt. Nach Zuführen zu der ersten Frequenzmesszelle 5 wird in einem ersten Schwingkreis die Ist-Frequenz ermittelt und mit der vorgegebenen Soll-Frequenz verglichen. Die Differenzfrequenz zwischen beiden Frequenzen wird der Korrektureinheit 8 übermittelt, was durch die Verbindung von der Frequenzmesszelle 5 zur Korrektureinheit 8 angedeutet ist. Die Korrektureinheit 8 steuert die Einkürzeinheit 7, welche nach Zuführen des gemessenen Schwingkreises zu derselben durch Einkürzen der Metallschicht(en) des Kondensators die Ist-Frequenz auf die Soll-Frequenz zu korrigieren versucht, indem sie die Kapazität des Kondensators erniedrigt. Die Steuerung der Einkürzeinheit 7 über die Korrektureinheit 8 ist durch die Verbindung zwischen diesen angedeutet. Das Einkürzen kann, wie hier beispielhaft angedeutet, durch Auslenkung eines Laser- oder Wasserstrahls erfolgen. Nach Zuführen des an der Einkürzeinheit 7 bearbeiteten Schwingkreises zu der zweiten Frequenzmesszelle 6 wird der Effektiv-Frequenzwert ermittelt, wonach dieser Wert an die Korrektureinheit 8 geht, was wiederum durch die Verbindung zwischen der Frequenzmesszelle 6 und der Korrektureinheit 8 angedeutet ist. Wenn der Effektiv-Frequenzwert innerhalb einer vorgegebenen Soll-Frequenzbandbreite liegt, bildet diese Effektiv-Frequenz einen neuen Ist-Wert für die Berechnung der neuen Position der Einkürzeinheit 7 für den nächsten sich an der Einkürzeinheit befindlichen Schwingkreis. Die für die Frequenzanpassung des sich nun an der zweiten Frequenzmesszelle 6 befindlichen Schwingkreises verwendete Position der Einkürzeinheit 7 dient somit als Basiswert für die Stellung der Einkürzeinheit bei der Frequenzanpassung des nächsten sich an der Einkürzeinheit befindenden Schwingkreises. Die über die Korrektureinheit 8 an die Einkürzeinheit 7 gerichteten Korrekturen sind somit üblicherweise gering, so dass ein schnelles und präzises diesbezügliches Einstellen der Einkürzeinheit 7 erfolgt.

Wenn dagegen die Effektiv-Frequenz ausserhalb der vorgegebenen Soll-Frequenzbandbreite liegt, welche durch die Verwendbarkeit der Schwingkreise definiert ist, wird dieser Schwingkreis markiert und für die Frequenzbandanpassung des nächsten sich an der Einkürzeinheit befindenden Schwingkreises wird dann dessen an der ersten Messzelle gemessener Ist-Frequenzwert für die Berechnung der Position der Einkürzeinheit verwendet.

Nach Trennen der Verbundfolienrollenware in einzelne Schwingkreise werden die nicht in die vorgegebene Frequenzbandbreite fallenden und markierten Schwingkreise ausgeschieden, was jedoch in der Fig. 1 nicht dargestellt ist.

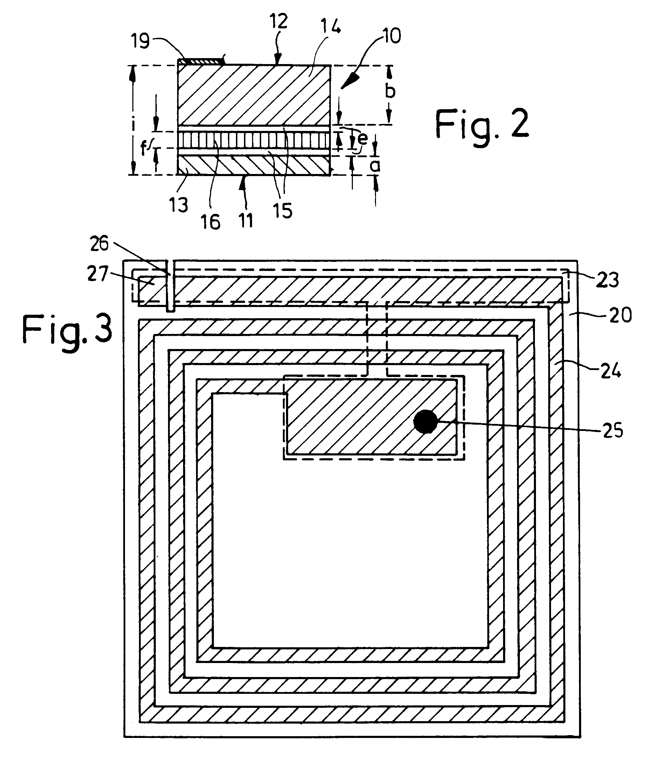

Fig. 2 zeigt beispielhaft eine Verbundfolie 10 der Gesamtdicke i, mit einer Aetzresistschicht 19 und einer Aluminiumschicht 13 der Dicke a sowie einer Aluminiumschicht 14 der Dicke b. Dazwischen liegt die Dielektrikumsschicht aus Kunststoff 16, welche von weiteren Dielektrikumsschichten 15 flankiert ist, die gleichzeitig gute Hafteigenschaften zu den Aluminiumschichten 13, 14 haben. Die Fig. 2 zeigt eine mögliche Ausführungsform der Verbundfolie für die Durchführung des erfindungsgemässen Verfahrens zur Frequenzanpassung, bei der die Dicke a der Aluminiumschicht 13 geringer ist als die Dicke b der Aluminiumschicht 14. Die Dicke a der Aluminiumschicht 13 kann 30 nm bis 150 µm, bevorzugt 12 bis 20 µm betragen. Die Dicke b der Aluminiumschicht 14 kann 30 nm bis 150 µm, bevorzugt 50 bis 100 µm betragen.

Die Dicke f der Dielektrikumsschicht aus Kunststoff 16 kann beispielsweise 5 bis 100 µm, bevorzugt 10 bis 20 µm, betragen. Die Dielektrikumsschichten 15, die gleichzeitig die Haftung zwischen den Schichten (16, 13; 16, 14) verbessern, können ein Flächengewicht von 0,01 bis 20 g/m² aufweisen.

In Fig. 3 bildet die spiralförmig angeordnete Leiterstruktur 24 den Spulenkörper und die übereinander liegenden Kondensatorflächen aus Metall den Kondensator 23 eines Schwingkreises. Zwischen den Metallschichten befindet sich das Dielektrikum 20, z.B. bestehend aus den Schichten 15, 16, 15, welches gleichzeitig Träger des Spulenteils 24 als auch des Kondensators 23 ist. Der in der Mitte angeordnete Block dient als Verbindungselement 25 an den elektrischen Stromkreis. Das Dielektrikum 20 ist zumindest teilweise gleichzeitig die den Schwingkreisen auf einer Verbundfolienrollenware gemeinsame Kunststoffolie, und wird zum quasi kontinuierlichen Zuführen der einzelnen Schwingkreise an die Frequenzmesszellen 5, 6 oder Einkürzeinheit 7 verwendet. Durch den Schnitt 26 wurde der Kondensator 23 um den Teil 27 eingekürzt und damit der Schwingkreis an das gewünschte Frequenzband angepasst.

## Patentansprüche

1. Verfahren zur Frequenzanpassung von elektrischen Schwingkreisen für Identifikationsetiketten, hergestellt aus einer Verbundfolie (10) in Form einer Metall-Kunststoff-Metall-Verbundfolienrollenware oder dergleichen, von denen jeder Schwingkreis einen in sich abgeschlossenen Stromkreis aufweist, enthaltend auf der einen Seite der Verbundfolie (10) eine spiralförmig angeordnete, eine Induktionsspule (24) bildende, Leiterstruktur sowie eine erste Kondensatorfläche (23,14) aus Metall und auf der anderen Verbundfolienseite eine der ersten Kondensatorfläche (23,14) gegenüberliegende zweite Kondensatorfläche (23,13) mit einer im Vergleich zur ersten Kondensatorfläche dünneren Metallschicht, wobei die Ist-Frequenz der einzelnen Schwingkreise unter einem vorgegebenen Soll-Frequenzliegen, die einzelnen Schwingkreise durch mindestens eine gemeinsame Kunststoffolie miteinander verbunden sind und quasi kontinuierlich fortbewegt werden, nach Zuführen eines Schwingkreises zu einer ersten Frequenzmesszelle (5) die Ist-Frequenz ermittelt und mit der vorgegebenen Soll-Frequenz verglichen wird, die Differenzfrequenz zwischen den beiden Frequenzen einer Korrektureinheit (8) übermittelt wird, wobei die Korrektureinheit (8) eine Vorrichtung (7) steuert, die nach Zuführen dieses Schwingkreises zu derselben durch Nacharbeiten des Kondensatorteils des Schwingkreises dessen Ist-Frequenz auf die Soll-Frequenz korrigiert,
dadurch gekennzeichnet, dass
die Anpassung der an der ersten Frequenzmesszelle (5) ermittelten Ist-Frequenz jedes Schwingkreises an die Soll-Frequenz durch Einkürzen seiner zweiten Kondensatorfläche (23,13) mittels einer die Vorrichtung (7) bildende Einkürzeinheit (7) geschieht, daß nach Zuführen desselben Schwingkreises zu einer zweiten Frequenzmesszelle (6) der Effektiv-Frequenzwert ermittelt wird, daß dann, wenn dieser innerhalb einer vorgegebenen Soll-Frequenzbandbreite liegt, dieser Effektiv-Frequenzwert als neuen Ist-Frequenzwert für die durch die Korrektureinheit (8) zu berechnende neue Position der Einürzeinheit (7) für die Korrektur der Resonanzfrequenz des nächsten sich an der Einkürzeinheit (7) befindlichen Schwingkreises dient oder daß dann, wenn der Effektiv-Frequenzwert ausserhalb der vorgegebenen Soll-Frequenzbandbreite liegt, derselbe Schwingkreis markiert und für die Frequenzbandanpassung des nächsten sich an der Einkürzeinheit (7) befindenden Schwingkreises, dessen Ist-Frequenzwert von der ersten Frequenzmesszelle (5) für die Berechnung der Position der Einkürzeinheit (7) verwendet wird.

2. Verfahren nach Anspruch 1, dadurch gekennzeichnet, dass die Messzellen (5,6) eine oszillierende Frequenzbandabtastung durchführen.

3. Verfahren nach Anspruch 1, dadurch gekennzeichnet, dass die Einkürzeinheit (7) im wesentlichen aus einem Stanzwerkzeug besteht und das Einkürzen durch dieses bewirkt wird.

4. Verfahren nach Anspruch 1, dadurch gekennzeichnet, dass die Einkürzeinheit (7) im wesentlichen aus einem Funkenerosionswerkzeug besteht und durch dieses die Einkürzung erfolgt.

5. Verfahren nach Anspruch 1, dadurch gekennzeichnet, dass die Einkürzeinheit (7) aus einem Schneidwerkzeug besteht und die Einkürzung durch dieses erfolgt.

6. Verfahren nach Anspruch 1, dadurch gekennzeichnet, dass die Einkürzeinheit (7) zum Einkürzen einen Wasserstrahlschnitt durch die MetallKunststoff-Metall-Verbundfolie ausführt.

7. Verfahren nach Anspruch 1, dadurch gekennzeichnet, dass die Einkürzeinheit (7) ein Laserstrahlaggregat enthält, welches die Einkürzung durch einen Schnitt durch die Metall-Kunststoff-Metall-Verbundfolie bewirkt.

8. Verfahren nach Anspruch 1, dadurch gekennzeichnet, dass sich zwischen der ersten Frequenz-Messzelle (5) und der zweiten Frequenz-Messzelle (6) nicht mehr als neun Schwingkreise, vorzugsweise drei bis fünf Schwingkreise, befinden.

9. Verfahren nach Anspruch 1, dadurch gekennzeichnet, dass die Einkürzeinheit (7) in eine der Frequenz-Messzellen (5,6), vorzugsweise in die erste Frequenz-Messzelle (5), integriert ist.

10. Verfahren nach einem der Ansprüche 1 bis 9, dadurch gekennzeichnet dass nach Trennen der Verbundfolienrollenware oder dgl. in einzelne Schwingkreise die nicht in der Soll-Frequenzbandbreite liegenden und markierten Schwingkreise ausgeschieden werden.

11. Verfahren nach Anspruch 3 oder 4, dadurch gekennzeichnet, dass das Einkürzen zur Vermeidung eines elektrischen Kontakts der Metallschichten (13, 14) von der Seite der Verbundfolie mit der dünneren Metallschicht (13) bewirkt wird.

12. Verfahren nach Anspruch 5, dadurch gekennzeichnet, dass die Einkürzung durch einen Schnitt von der Seite der Verbundfolie mit der dünneren Metallisierungsschicht (13) bewirkt und dabei die dünnere Schicht (13) vollständig durchschnitten wird, und die darunterliegende(n) Schicht(en) (16 bzw. 15, 16, 15) höchstens angeschnitten werden.

## Claims

1. Process for adapting the frequency of an electric oscillating circuit for identification labels made from a sandwich foil (10) in the form of a roll of metal-plastic-metal sandwich foil or the like, each oscillating circuit having a self-contained circuit, containing a spirally arranged conductive pattern forming an induction coil (24) and a first capacitor surface (23, 14) of metal on one side of the sandwich foil (10) and a second capacitor surface (23, 13) lying opposite the first capacitor surface (23, 14) with a thinner metal layer compared to the first capacitor surface on the other side of the sandwich foil, the actual frequency of the individual oscillating circuits lying below a given nominal frequency, the individual oscillating circuits being connected to one another by at least one common plastic foil and being advanced almost continuously, once an oscillating circuit has been fed to a first frequency measuring cell (5) the actual frequency being determined and compared with the given nominal frequency, the frequency difference between the two frequencies being transmitted to a correction unit (8), the correction unit (8) controlling a device (7) which, once this oscillating circuit has been fed thereto, corrects its actual frequency to the nominal frequency by additional working of the capacitor part of the oscillating circuit, characterised in that the actual frequency of each oscillating circuit determined at the first frequency measuring cell (5) is adapted to the nominal frequency by reducing its second capacitor surface (23, 13) by means of a reduction unit (7) forming the device (7), that once the said oscillating circuit has been fed to a second frequency measuring cell (6) the effective frequency value is determined, that then, if this lies within a given nominal frequency bandwidth, this effective frequency value serves as a new actual frequency value for the new position of the reduction unit (7) to be calculated by the correction unit (8) for correcting the resonance frequency of the next oscillating circuit situated at the reduction unit (7), or that then, if the effective frequency value lies outside the given nominal frequency bandwidth, the said oscillating circuit is marked and its actual frequency value from the first measuring cell (5) is used to calculate the position of the reduction unit (7) for adapting the frequency band of the next oscillating circuit situated at the reduction unit (7).

2. Process according to claim 1, characterised in that the measuring cells (5, 6) carry out oscillating frequency band sampling.

3. Process according to claim 1, characterised in that the reduction unit (7) consists essentially of a stamping tool which is used to perform the reduction.

4. Process according to claim 1, characterised in that the reduction unit (7) consists essentially of a spark erosion tool which is used to effect the reduction.

5. Process according to claim 1, characterised in that the reduction unit (7) consists of a cutting tool which is used to effect the reduction.

6. Process according to claim 1, characterised in that the reduction unit (7) effects a water jet cut through the metal-plastic-metal sandwich foil for reduction.

7. Process according to claim 1, characterised in that the reduction unit (7) contains a laser beam aggregate which performs the reduction by means of a cut through the metal-plastic-metal sandwich foil.

8. Process according to claim 1, characterised in that not more than nine oscillating circuits and preferably three to five oscillating circuits are situated between the first frequency measuring cell (5) and the second frequency measuring cell (6).

9. Process according to claim 1, characterised in that the reduction unit (7) is integrated into one of the frequency measuring cells (5,6), preferably into the first frequency measuring cell (5).

10. Process according to one of claims 1 to 9, characterised in that, once the roll of sandwich foil or the like has been separated into individual oscillating circuits, the marked oscillating circuits not lying in the nominal frequency bandwidth are removed.

11. Process according to claim 3 or claim 4, characterised in that reduction is effected from the side of the sandwich foil with the thinner metal layer (13) in order to prevent electrical contact between the metal layers (13, 14).

12. Process according to claim 5, characterised in that reduction is performed by means of a cut from the side of the sandwich foil with the thinner metal layer (13) and thus the thinner layer (13) is cut through completely and the layer(s) (16 and 15, 16, 15) situated therebelow are at most cut into.

## Revendications

1. Procédé d'adaptation de la bande de fréquence de circuits électriques résonnants pour étiquettes d'identification, fabriqués à partir d'une feuille composite (10) sous forme d'une feuille composite en rouleau métal-plastique-métal ou analogue, dont chaque circuit résonnant présente un circuit distinct en soi, contenant, sur la première face de la feuille composite (10), une structure conductrice disposée en forme de spirale et formant une bobine d'induction (24), ainsi qu'une première surface de condensateur (23, 14) en métal et, sur l'autre face de la feuille composite, une seconde surface de condensateur (23, 13), située en face de la première surface de condensateur (23, 14), avec une couche métallique plus mince en comparaison de la première surface de condensateur, procédé dans lequel la fréquence réelle des différents circuits résonnants a une valeur inférieure à une fréquence prescrite, dans lequel les différents circuits résonnants sont reliés l'un à l'autre par au moins une feuille de plastique commune et sont entraînés de façon quasi-continue, dans lequel, après avoir amené un circuit résonnant à une première cellule (5) de mesure de la fréquence, on détermine la fréquence réelle et on la compare avec la fréquence prescrite, la différence entre les deux fréquences étant transmise à un organe de correction (8), et dans lequel l'organe de correction (8) commande un dispositif (7) qui, après arrivée de ce circuit résonnant dans ce dispositif, par une nouvelle intervention sur la partie du circuit résonnant formant condensateur, corrige sa fréquence réelle pour l'amener à la fréquence prescrite,
procédé caractérisé,
par le fait que l'adaptation de la fréquence réelle de chaque circuit résonnant, établie dans la première cellule (5) de mesure de la fréquence, à la fréquence prescrite se fait par raccourcissement de sa seconde surface de condensateur (23, 13) au moyen d'un organe de raccourcissement (7) formant le dispositif (7), par le fait qu'après arrivée de ce même circuit résonnant dans une seconde cellule (6) de mesure de la fréquence on établit la valeur effective de la fréquence, par le fait qu'ensuite, si celle-ci se situe à l'intérieur d'une largeur de bande de fréquence prescrite, cette valeur effective de la fréquence sert de nouvelle valeur réelle de la fréquence pour la nouvelle position de l'organe de raccourcissement (7) à calculer par l'organe de correction (8) pour la correction de la fréquence de résonance du circuit résonnant suivant se trouvant dans l'organe de raccourcissement (7), ou bien, par le fait qu'alors, si la valeur effective de la fréquence se situe à l'extérieur de la largeur de la bande de fréquence prescrite, ce même circuit résonnant est repéré et, pour l'adaptation de la bande de fréquence du circuit résonnant suivant se trouvant dans l'organe de raccourcissement (7), c'est la valeur de sa fréquence réelle, fournie par la première cellule (5) de mesure de la fréquence, que l'on emploie pour le calcul de la position de l'organe de raccourcissement (7).

2. Procédé selon la revendication 1, caractérisé par le fait que les cellules de mesure (5, 6) procèdent à un balayage oscillant de la bande de fréquence.

3. Procédé selon la revendication 1, caractérisé par le fait que l'organe de raccourcissement (7) est essentiellement constitué d'un outil de poinçonnage et que le raccourcissement est opéré par cet outil.

4. Procédé selon la revendication 1, caractérisé par le fait que l'organe de raccourcissement (7) est essentiellement constitué d'un outil d'électro-érosion et le raccourcissement est effectué par cet outil.

5. Procédé selon la revendication 1, caractérisé par le fait que l'organe de raccourcissement (7) est constitué d'un outil de découpe et que le raccourcissement est effectué par cet outil.

6. Procédé selon la revendication 1, caractérisé par le fait que l'organe de raccourcissement (7) procède, pour le raccourcissement à une découpe de la feuille composite métal-plastique-métal au jet d'eau.

7. Procédé selon la revendication 1, caractérisé par le fait que l'organe de raccourcissement (7) contient un groupe de fabrication d'un rayon laser qui opère le raccourcissement par une découpe de la feuille composite métal-plastique-métal.

8. Procédé selon la revendication 1, caractérisé par le fait qu'entre la première cellule (5) de mesure de la fréquence et la seconde cellule (6) de mesure de la fréquence se trouvent pas plus de neuf circuits résonnants, de préférence de trois à cinq circuits résonnants.

9. Procédé selon la revendication 1, caractérisé par le fait que l'organe de raccourcissement (7) est intégré dans l'une des cellules (5, 6) de mesure de la fréquence, de préférence dans la première cellule (5) de mesure de la fréquence.

10. Procédé selon l'une des revendications 1 à 9, caractérisé par le fait qu'après séparation de la feuille composite en rouleau ou analogue en les différents circuits résonnants, on élimine les circuits résonnants qui ne se trouvent pas sur la largeur de bande de la fréquence prescrite et sont repérés.

11. Procédé selon la revendication 3 ou 4, caractérisé par le fait que, pour éviter un contact électrique des couches métalliques (13, 14), on procède au raccourcissement par le côté de la feuille composite comportant la couche métallique la plus mince (13).

12. Procédé selon la revendication 5, caractérisé par la fait que le raccourcissement est opéré par une découpe faite du côté de la feuille composite présentant la couche de métallisation la plus mince (13) et que cette couche plus mince (13) y est complètement découpée, tandis que la couche ou les couches (16 ou 15, 16, 15) situées par dessous sont au maximum entamées.
